# EUROPEAN PATENT APPLICATION

(11) **EP 1 318 078 A1**
(43) Date of publication of application: **11.06.2003**
(21) Application number: 01958438.2
(22) Date of filing: 23.08.2001
(51) Int. Cl.: B65D 33/08, B65D 85/38

(54) **PACKAGING BAG FOR SEMICONDUCTOR WAFER AND METHOD OF PACKAGING SEMICONDUCTOR WAFER USING THE PACKAGING BAG**

(30) Priority: 29.08.2000 JP 2000258517
(71) Applicant: SHIN-ETSU HANDOTAI COMPANY LIMITED, Chiyoda-ku Tokyo 100-0005 (JP)
(72) Inventor: TOYAMA, Kohei, Shin-Etsu Handotai Co., Ltd., Nishirakawa-gun, Fukushima 961-8061 (JP); SHIMIZU, Tsubasa, Fujimori PlaChemical Co., Ltd., Kawasaki-shi, Kanagawa 211-0063 (JP)
(74) Representative: Cooper, John
(86) International application number: JP0107227
(87) International publication number: WO02018220

(57) **Abstract**

There is provided a packaging bag 1 for semiconductor wafer for packaging a shipping container having semiconductor wafers stored therein, wherein the packaging bag is provided with a handle 4. The handle is preferably formed of a welded part 2 and hole 3 opened in the welded part, particularly, a plurality of holes having circular or elliptical shape are preferably provided in the welded part. Whereby there is provided a packaging bag which enables even a heavy shipping container having wafers of large diameter stored therein to be easily taken in and out of an external box, and enables a workability to improve.

## Description

### Technical field

The present invention relates to a packaging bag used in shipment of semiconductor wafers and a method of packing semiconductor wafers.

### Background Art

A conventional process from production to shipment of semiconductor wafer such as silicon wafer generally comprises steps of slicing a semiconductor ingot grown in accordance with Czochralski method or the like, chamfering, lapping, heat treatment, etching, polishing, inspection, and the like to obtain mirror-polished wafers. Subsequently, these mirror-polished wafers are stored in a shipping container in several or dozens unit. After the shipping container is packaged in a bag, the packaged container is put together with cushioning members in an external box such as a corrugated box, and the external box is sealed with an adhesive tape or the like. Thus the wafers are packed and then shipped.

Recently, semiconductor wafers become larger in diameter, and in these days, for example, silicon wafers having a diameter of about 300 mm are coming into the market. If a shipping container accommodates such wafers of large diameter in dozens unit, its volume and weight are increased. In the case that a shipping container stores silicon wafers having a diameter of 300 mm, it reaches a weight of about 10 kg per container.

As to semiconductor wafers having a diameter of less than 300 mm, in general, a plurality of containers are stored in one external box to perform transportation or the like. However, as described above, if wafers having a diameter of 300 mm are stored in shipping containers, since even one shipping container has large volume and weight, one shipping container is put and packed in one external box.

Fig. 4 shows a workflow from storing one shipping container per external box to packing it. A shipping container 6 accommodating semiconductor wafers is packaged in a packaging bag 11 composed of so-called an aluminum-laminate which is formed by laminating films of aluminum and synthetic resin. Subsequently, the shipping container 6 packaged in the bag 11 is stored together with cushioning members 7a and 7b in an external box 8, and the external box 8 is sealed with an adhesive tape or the like. Thus the wafers are packed and transported to the destination.

In the destination, the external box 8 is unsealed, the upper cushioning member 7a is removed, and the shipping container 6 accommodating wafers is taken out together with the packaging bag 11 as a whole.

As to conventional wafers having small diameter, a shipping container itself for them is small and even when the wafers are stored in the shipping container, its weight is 5 kg at most, so that the shipping container can be taken out easily. However, as to wafers having a large diameter of 300 mm, each shipping container accommodating the wafers reaches the weight of about 10 kg as described above, so that it is too heavy to take the shipping container out of an external box by one hand and it is difficult to handle the container as in handling the shipping container accommodating wafers of small diameter. Since the packaging bag 11 for packaging the shipping container is not designed to easily take it out with one hand, workers have to very carefully handle the wafers which would crack easily and take out the packaged container with both hands. Accordingly, there are problems that workers have a bigger workload, workability is lowered, and in some cases, a worker drops the shipping container, so that semiconductor wafers accommodated therein are broken.

### Disclosure of the Invention

The present invention has been accomplished in view of the problems mentioned above, and its major object is to provide a packaging bag for semiconductor wafer that enables even a heavy shipping container accommodating wafers of large diameter to easily be taken into and out of an external box, and enables a workability to improve.

In order to solve the aforementioned problems, the present invention provides a packaging bag for packaging a shipping container having semiconductor wafers stored therein, wherein the packaging bag is provided with a handle.

As described above, since the packaging bag is provided with a handle, the shipping container packaged by the bag can be pulled up with one hand in particular when it is taken out of an external box, even if it has a weight of about 10 kg. Therefore, workers can work easily, their workload is drastically reduced, and dropping of the shipping container is prevented.

It is preferable that the handle is formed of a welded part of the packaging bag and hole opened in the welded part.

By opening a hole(s) into which worker's fingers are inserted in the welded part of the packaging bag, the handle can be easily formed, and strength of the handle itself can be sufficiently maintained.

Particularly, if the handle is formed by providing a plurality of holes therein, a worker can insert his fingers thereinto easily and handle the packaging bag more easily, and breakage or the like of the handle can be prevented effectively. Even if a heavy shipping container is packaged therein, the packaged shipping container can be easily pulled up from an external box by one hand.

It is preferable that the packaging bag is composed of a laminate comprising films of two or more materials selected from the group of polyethylene terephthalate, polyethylene, polyamide and aluminum.

Since the packaging bag which is formed of a laminate formed by laminating the above films can keep semiconductor wafers clean, and after a shipping container is stored in the packaging bag, heat sealing can be easily performed to seal the packaging bag. Moreover, if a handle is formed by opening a hole(s) in the welded part, strength of the handle can be sufficiently maintained.

The present invention further provides a method of packing semiconductor wafer that comprises the steps of storing semiconductor wafers in a shipping container, packaging the shipping container in a packaging bag, and storing the packaged container together with cushioning members in an external box, wherein the shipping container is packaged in the aforementioned packaging bag according to the present invention.

As described above, in the case of packing semiconductor wafers, if the aforementioned packaging bag according to the present invention is used, the packaging bag can be easily pulled up by gripping the handle of the bag when the shipping container packaged in the bag is taken out of an external box. Accordingly, workability in unpacking the box can be improved, and breakage or the like of semiconductor wafers as products can be prevented.

The packaging bag according to the present invention for packaging the shipping container accommodating semiconductor wafers is characteristically provided with a handle. Accordingly, if the shipping container accommodating semiconductor wafers is packaged in this packaging bag and the packaged container is put together with cushioning members in an external box and packed, the packing can be easily performed. Moreover, when the box is unpacked in the destination, the packaging bag can be firmly held by using the handle, so that the shipping container with the packaging bag as a whole can be easily pulled out of the external box.

Particularly, if the handle is formed by providing a plurality of circular holes possible to insert worker's fingers thereinto in the welded part of the bag, the handle can be easily formed. Moreover, even if a heavy shipping container having semiconductor wafers of a diameter of 300 mm stored therein is packaged in the bag, since strength of the handle can be sufficiently maintained and the packaging bag can be pulled up with one hand, workload of workers can be reduced and workability can be improved. Additionally, accidental dropping of the shipping container together with the packaging bag can be prevented during packing and unpacking.

### Brief Explanation of the Drawings

Fig. 1 is a schematic view showing one example of packaging bag according to the present invention.
Fig. 2 is a partial schematic view showing another example of handle provided in the packaging bag according to the present invention.
Fig. 3 is a schematic view showing a condition that a shipping container is accommodated in the packaging bag shown in Fig. 1.
Fig. 4 is a flow chart from storing a shipping container accommodating semiconductor wafers in an external box to packing it.
Figs. 5 are partial schematic views showing other examples of handle provided in the packaging bag according to the present invention.
Fig. 6 is a partial schematic view showing another example of handle provided in the packaging bag according to the present invention.

### Best Mode for Carrying out the Invention

Embodiments of the present invention will be further explained specifically with reference to the drawings. However, the present invention is not limited thereto.

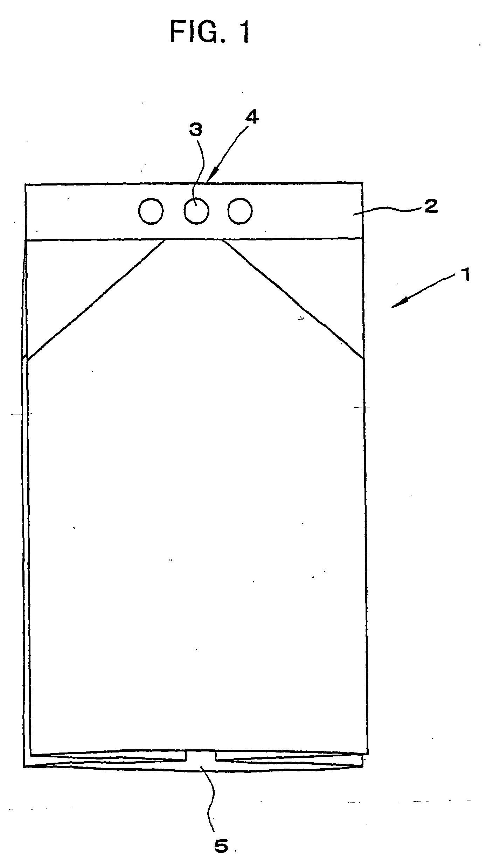

Fig. 1 shows one example of packaging bag according to the present invention. One end of the packaging bag 1 shown herein is widely welded, and three circular holes 3 are opened approximately in the center of the welded part 2 to form a handle 4. Besides, the other end of the bag 1 serves as an opening 5, and after a shipping container (not shown) accommodating wafers is put in the bag 1, the opening 5 is heat-sealed (welded) in order to package the shipping container.

Although the number or the shape of hole to form a handle is not limited in particular, it is preferable that a plurality of circular or elliptical holes having a size such that enables a worker to insert his one finger or plural fingers thereinto are provided in the welded part, so that the worker can easily put his finger(s) therein and the handle has sufficient strength. Particularly, if a plurality of circular holes having a diameter of from 1.5 cm to 4 cm, specifically two to five holes, preferably two or three holes, are provided in the welded part, a worker can pull up the bag by inserting his finger into each hole as well as the handle has more sufficient strength.

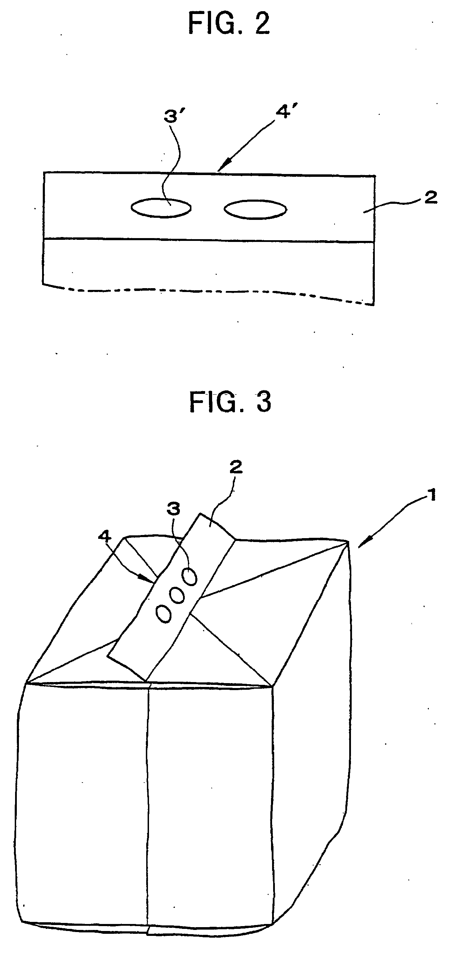

Fig. 2 shows another example of handle provided in the packaging bag according to the present invention. As it shows, even if a handle 4' is formed by opening elliptical holes 3' in a welded part 2, the handle 4' is easily gripped and sufficient strength thereof can also be maintained. Besides, as an alternative to the above-described circular or elliptical hole, a rounded hole may be opened in the welded part, so that the handle can be very easily provided therein and show its sufficient strength as a handle. In this case, although it is of course possible that polygonal holes such as quadrilaterals are opened in the welded part. However, since stress may concentrate on corners of the holes, it is preferred that the corner has R-shape or chamfered shape.

As to the position of the hole, if the hole is provided too close to a peripheral portion of the bag 1, the handle can not have sufficient strength. Therefore, although strength of its material should also be considered, the hole is preferably formed at a position apart from the upper end by 1 cm or more, more preferably 2 cm or more, and in consideration of its balance, the hole is preferably formed near the center of a welded part 2. Besides, if a plurality of holes are opened in the welded part, the holes are preferably formed while leaving a proper space between the holes in order to easily insert fingers thereinto.

If the holes are opened in the welded part as described above, when a shipping container is packaged in this bag, even though its content (the shipping container accommodating wafers) is relatively heavy, a worker can easily lift it up. Moreover, if a plurality of holes are provided therein, since a worker can easily insert his fingers into the holes, he can handle the bag more easily, and since load is distributed to each hole, breakage or large deformation of holes can be prevented effectively. In this regard, when circular holes 3 as shown in Fig. 1 are opened in the welded part, so-called grommets may be attached to the holes to increase strength thereof.

As to the material of the packaging bag, any material conventionally used for such a bag, such as synthetic resin or so-called an aluminum-laminate formed by laminating films of synthetic resin and aluminum, can be used without limitation. Particularly, any laminate comprising two or more films of materials selected from the group of polyethylene terephthalate, polyethylene, polyamide (nylon) and aluminum can be preferably used. If a packaging bag is produced of the above-described laminated films, the opening of the bag can be easily heat-sealed after a shipping container is packaged in the bag, and even if holes are opened in the welded part of the laminated films to provide a handle therein, the handle has sufficient strength. Moreover, the bag formed of these films has an excellent function such that semiconductor wafers are kept clean.

The form of the packaging bag is not limited either in particular so far as the bag is capable of packaging a shipping container, but so-called a gusset bag like the packaging bag 1 shown in Fig. 1 is suitable for packaging the shipping container of three dimensions. Since the packaging bag 1 shown in Fig. 1 is partially welded downward approximately in the triangular shape following the welded part 2 where holes 3 are opened, the packaging bag 1 does not loosen in its upper portion even when the packaging bag 1 is lifted up by inserting fingers into the holes 3.

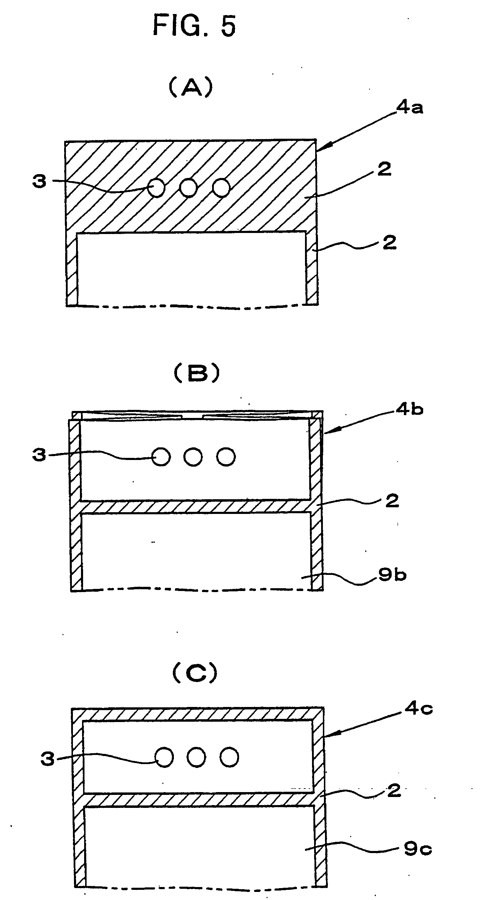

The production method of the bag itself is not limited either in particular, but the gusset bag as shown in Fig. 1 can be easily produced by superposing films as its material and welding them along the peripheral portion except an opening of they bag. Namely, a gusset bag itself having no handle can be produced with a common bag-making machine. In order to provide such a bag with a handle, an upper end portion of the bag, which had been conventionally welded for simply closing the bag, is welded with a relatively wide margin, for example, with about 5 cm to 8 cm wide. Subsequently, holes having any shape are punched in the upper end welded part by using a punching machine. According to such a method, a packaging bag of which handle portion 4a is welded in whole as shown in Fig. 5 (A) can be produced.

As to the weld of the handle portion, the handle portion must not be necessarily welded in whole, and the handle portion may be welded to keep airtightness of the bag after packaging a shipping container in the bag and to serve as a handle.

As shown in Fig. 5(B), for example, if there is welded with a width having at least about 1 cm between apportion to be a handle and a portion for packaging the shipping container, the handle portion 4b can be divided from the packaging portion 9b, thereby obtaining the packaging bag of the present invention. Moreover, as shown in Fig 5(C), if there is also welded with a width having about 1 cm in an upper end portion of the packaging bag, the easiness of holding the handle and the strength thereof can be improved while the handle portion 4c can be divided from the packaging portion 9c.

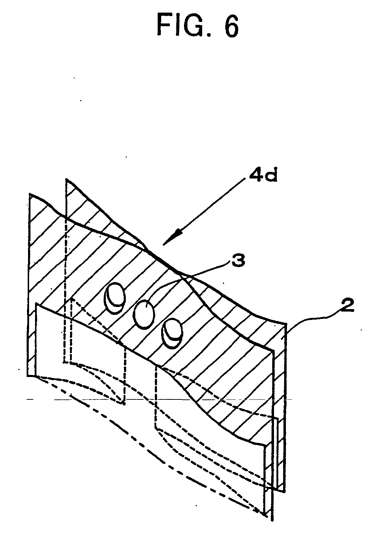

In a turn-in type gusset bag, there are a portion (near the center of the bag) where films are folded in double and the other portion (both sides of the bag) where films are folded in quadruple. In the handle portion, it is preferable that all of the folded films are integrally welded as a whole so that its strength can be highly maintained. However, both films turned inside the bag must not be necessarily welded with each other, and even if there is welded in every two layers as shown in Fig. 6, the strength of the handle 4d can be sufficiently maintained.

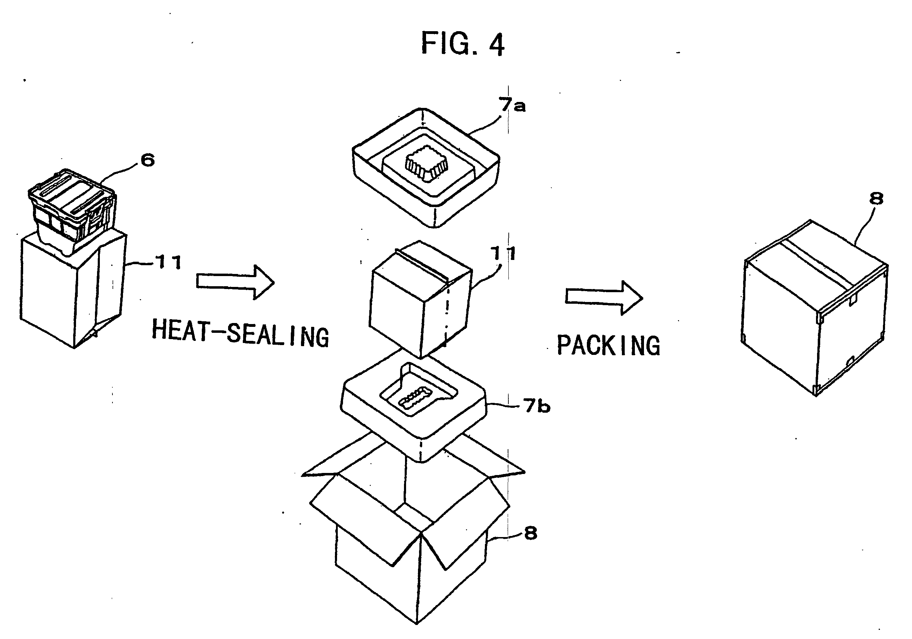

The following is the workflow from packing semiconductor wafers to unpacking them using the packaging bag according to the present invention. First, semiconductor wafers are stored in a shipping container, after the shipping container is put in a packaging bag 1 as shown in Fig. 1 through an unfolded opening 5, the opening 5 is welded with a common heat sealing machine, so that the container 1 can be easily packaged. Fig. 3 shows that the shipping container is packaged in the packaging bag 1 as shown in Fig. 1. The opening 5 is welded and thereby the shipping container is packaged in the bag.

Next, the shipping container packaged in the bag 1 is stored together with cushioning member in an external box. The shipping container can be easily stored in the external box by gripping a handle 4 of the packaging bag 1.

The above-mentioned cushioning member is not limited in particular. The cushioning members, which has the shape fitting the shipping container existing in the bag, are placed on the upper and lower sides of the shipping container packaged in the bag in order to store them in an external box such as a corrugated box, and the external box is sealed with adhesive tape, staples or the like to perform packing. Whereby the cushioning members can absorb external shocks and the shipping container can be positioned in place within the external box. Accordingly, movement of the shipping container within the external box can be suppressed and damages or the like of the wafers can be prevented more effectively.

After the shipping container (semiconductor wafers) packed above is transported to customers or the like, it is unpacked. When the external box is opened and the cushioning member therein is taken out, the packaging bag, which is provided with the handle, accommodating the shipping container can be easily pulled out of the external box by utilizing the handle. In this regard, if the shipping container is packed so that the handle 4 faces the upper surface of the external box when it is put in the external box, the shipping container can be pulled up together with the bag as a whole by holding the handle 4 after the upper surface of the shipping container is opened and the upper cushioning member is taken off.

Particularly, as shown in Fig. 1 and Fig.2, if the packaging bag is provided with the handle 4 by opening holes 3 in the welded part 2, a part of the bag 1 (handle 4), which is located above the holes 3, can be held by inserting worker's fingers into each hole 3. And even if a shipping container is heavy due to accommodating silicon wafers having a large diameter of 300 mm, it can be easily pulled out of the external box with one hand.

There is explained above the case of using the packaging bag with the handle formed by punching a plurality of holes having circular or elliptical shape in the welded part. However, for example, it is possible that a U-shaped handle composed of the same material as the packaging bag or any kind of synthetic resins is attached to the welded part of the bag by welding or with an adhesive, i.e., a shape or form of the handle is not limited in particular.

The number of the shipping container to be stored in the external box is not limited to one, and even in a case that a plurality of shipping containers are stored in one external box, the handle can be also provided in the packaging bag.

The present invention will be explained more specifically as described in the example below, but the present invention is not limited thereto.

### (Example)

Bags were prepared, in which holes having various shapes such as circular or elliptical shape were punched in a welded part of generally called aluminum-laminated bag, and after a shipping container accommodating wafers of a diameter of 300 mm was put into each bag through its opening, the shipping container was packaged by welding the opening of the bag. The material of the aluminum-laminated bag used therein was one formed by laminating a nylon film (15µm); an aluminum film (12 µm); a polyethylene film (20µm); and a polyethylene film (40µm) from the outside.

The bags packaging the shipping container as described above were lifted up by inserting fingers into the holes to determine the strength of the holes. The result was that the bag having three circular holes of a diameter of 25 mm provided in its welded part to form a handle was able to be lifted up easily, in addition, and the shape of the holes were almost not deformed and they had excellent strength.

Besides, a shipping container accommodating wafers of a diameter of 300 mm is packaged in each of the above-described packaging bag according to the present invention (having three circular holes of a diameter of 25 mm in its welded part) and a conventional packaging bag, and the comparison between the bags was conducted in terms of a working time required for taking it out of an external box.

As a result, if the working time in the case of using the conventional packaging bag was defined as 1, the working time in the case of using the packaging bag of the present invention could be equivalent to 0.6-0.7, i.e., the working time was reduced. Additionally, the packaging bag of the present invention could be securely held by its handle, and it never occurred that wafers stored in the shipping container were broken due to dropping.

The present invention is not limited to the embodiment described above. The above-described embodiment is a mere example, and those having substantially the same structure as that described in the appended claims and providing the similar functions and advantages are included in the scope of the present invention.

As a matter of course, for example, the packaging bag according to the present invention is not limited to packaging of the shipping container accommodating wafers of a large diameter of 300 mm, and it can be also applied to packaging a shipping container accommodating wafers of a diameter of less than 300 mm or a lager diameter of 300 mm or more in the bag and then packing the wafers by taking the bag in an external box.

Besides, the form of the bag and the producing method of the bag itself are not limited either, i.e., the bag is not limited to a turn-in type gusset bag as shown in Fig. 1. For example, it is possible that a shipping container is put between sheets or films as packaging material from its top and bottom, thereafter three sides or four sides of the packaging materials are subjected to thermocompression bonding in order to package the shipping container, and a portion which serves as a handle is formed after packaging the shipping container. Such a packaging form can also be taken in and out of an external box by holding the handle portion.

## Claims

1. A packaging bag for semiconductor wafer for packaging a shipping container having semiconductor wafers stored therein, wherein the packaging bag is provided with a handle.

2. The packaging bag for semiconductor wafer according to claim 1, wherein the handle is formed of a welded part of the packaging bag and hole opened in the welded part.

3. The packaging bag for semiconductor wafer according to claim 2, wherein a plurality of holes are opened in the welded part.

4. The packaging bag for semiconductor wafer according to any one of claims 1-3, wherein the packaging bag is composed of a laminate comprising two or more films of materials selected from the group of polyethylene terephthalate, polyethylene, polyamide and aluminum.

5. A method of packing semiconductor wafer that comprises the steps of storing semiconductor wafers in a shipping container, packaging the shipping container in a packaging bag, and storing the packaged container together with cushioning members in an external box, wherein the shipping container is packaged in the packaging bag according to any one of claims 1-4.
